# EUROPÄISCHE PATENTSCHRIFT

(11) **EP 2 802 789 B1**
(45) Veröffentlichungstag und Bekanntmachung des Hinweises auf die Patenterteilung: **27.07.2016**
(21) Anmeldenummer: 13700371.1
(22) Anmeldetag: 07.01.2013
(51) Int. Cl.: F16F 9/084, B60G 15/14, B60G 11/62

(54) **FEDERBEIN FÜR EIN FAHRZEUG**
SUSPENSION STRUT FOR A VEHICLE
JAMBE DE FORCE POUR UN VÉHICULE

(30) Priorität: 11.01.2012 DE 102012000349
(43) Veröffentlichungstag der Anmeldung: 19.11.2014
(73) Patentinhaber: ThyssenKrupp Bilstein GmbH, 58256 Ennepetal (DE)
(72) Erfinder: REICHMANN, Olaf, 44869 Bochum (DE); WERNER, Steffen, 58339 Breckerfeld (DE); MEINERT, Georg, 58636 Iserlohn (DE); ADAM, Mirco, 44581 Castrop-Rauxel (DE)
(74) Vertreter: ThyssenKrupp Intellectual Property GmbH
(86) Internationale Anmeldenummer: PCT/EP2013/050148
(87) Internationale Veröffentlichungsnummer: WO 2013/104579

(56) Entgegenhaltungen:
- DE-A1- 3 501 651
- DE-A1- 4 010 982
- DE-A1- 10 041 927
- DE-B4- 10 207 102
- DE-C1- 19 508 980
- DE-C1- 19 908 606
- US-B1- 6 341 678

## Beschreibung

Die vorliegende Erfindung betrifft ein Federbein für ein Fahrzeug mit einer Luftfedereinheit und einer Dämpfereinheit, welche Dämpfereinheit ein Dämpferrohr aufweist, das sich in ein Abrollrohr der Luftfedereinheit hinein erstreckt, wobei das Dämpferrohr auf seinem Umfang verteilt angeordnete Abstützgeometrien aufweist, gegen die ein radial erweitertes Ende des Abrollrohres abgestützt ist.

### STAND DER TECHNIK

Aus der DE 102 07 102 B4 ist ein Federbein für ein Fahrzeug mit einer Luftfedereinheit und einer Dämpfereinheit bekannt, und die Dämpfereinheit weist ein Dämpferrohr auf, das sich in ein Abrollrohr der Luftfedereinheit hinein erstreckt. Zur Abstützung des Abrollrohres am Dämpferrohr weist das Dämpferrohr Abstützgeometrien auf, die als Ausprägungen mit einer Schulter ausgeführt sind und gegen die das Ende des Abrollrohres abstützt ist.

Der Innendurchmesser des Abrollrohres ist im Bereich der Abstützung gegen das Dämpferrohr mit einem nur geringfügig größeren Durchmesser ausgeführt, so dass das Abrollrohr mit dem Dämpferrohr eine im Wesentlichen starre Anordnung ergibt.

im Abrollrohr ist ein Gasraum für die Funktion der Luftfedereinheit gebildet und der unter Druck gesetzt ist, sodass das Abrollrohr gegen das Dämpferrohr abgedichtet werden muss. Um die erforderliche Dichtwirkung zwischen dem Abrolirohr und dem Dämpferrohr zu erreichen, ist eine von den Abstützgeometrien beabstandete Nut im Dämpferrohr eingebracht, in die ein O-Ring eingelegt ist, der gegen die Innenseite des Abrollrohres eine Dichtwirkung erzielt, wodurch jedoch eine aufwendige Gesamtanordnung entsteht.

Als wesentlicher Nachteil ergibt sich zwischen dem Abrollrohr und dem Dämpferrohr jedoch keine Nachgiebigkeit, so dass kein Ausgleich von Querkräften, insbesondere von Verkippungen des Dämpferrohres im Abrollrohr ermöglicht ist und wodurch der Fahrkomfort des Fahrzeugfahrwerkes mit einem derartigen Federbein beeinträchtigt ist.

Die DE 195 08 980 C2 zeigt ein Federbein für ein Fahrzeug nach einer weiteren Ausführungsform mit einer Luftfedereinheit und einer Dämpfereinheit, und ein Abrollrohr der Luftfedereinheit ist gegen ein Dämpferrohr der Dämpfereinheit mittels eines elastischen Ringteils gehalten. Durch die Nachgiebigkeit im Ringteil können Verkippungen des Abrollrohres gegen das Dämpferrohr ausgeglichen werden, wobei jedoch das Dämpferrohr keine in segmentierten Bereichen ausgebildete Abstützgeometrie aufweist, und die Abstützung des Ringteils erfolgt gegen einen kragenartigen Flansch, der auf dem Außenumfang des Dämpferrohres angeordnet ist.

Die DE19908606 C1, DE 3501651 A1 und DE 4010982 A1 zeigen weitere relevante Federbeine für Fahrzeuge.

Im Betrieb eines Federbeins der vorliegenden Bauart können neben Querkräften und damit hervorgerufene Verkippungen des Abrollrohres am Dämpferrohr weitere Belastungen auftreten, und zur weiteren Verbesserung des Fahrkomforts es ist beispielsweise wünschenswert, zwischen der Dämpfereinheit und der Luftfedereinheit auftretenden Drehmomente zu übertragen. Ein Federbein, das eine starre Anordnung zwischen dem Dämpferrohr und dem Abrollrohr aufweist, kann zwar eine Drehmomentübertragung zwischen dem Dämpferrohr und dem Abrollrohr ermöglichen, jedoch wird durch die starre Anordnung der Fahrkomfort negativ beeinträchtigt. Wird hingegen ein Ringteil aus einem Elastomer verwendet, um Verkippungen des Abrollrohres am Dämpferrohr auszugleichen, können nachteilhafterweise jedoch keine Drehmomente übertragen werden.

### OFFENBARUNG DER ERFINDUNG

Es ist die Aufgabe der vorliegenden Erfindung, ein Federbein für ein Fahrzeug zu schaffen, mit dem die vorstehend bezeichneten Nachteile des Standes der Technik überwunden werden, insbesondere ist es die Aufgabe, ein Federbein mit einem erhöhten Fahrkomfort zu schaffen, das eine verbesserte Abstützung des Abrollrohres auf dem Dämpferrohr ermöglicht.

Diese Aufgabe wird ausgehend von einem Federbein gemäß dem Oberbegriff des Anspruchs 1 in Verbindung mit den kennzeichnenden Merkmalen gelöst. Vorteilhafte Weiterbildungen der Erfindung sind in den abhängigen Ansprüchen angegeben.

Die Erfindung schließt die technische Lehre ein, dass zur Abstützung des Abrollrohres an den Abstützgeometrien des Dämpferrohres ein Torsionselement vorgesehen ist, welches Torsionselement zwischen dem radial erweiterten Ende des Abrollrohres und den Abstützgeometrien des Dämpferrohres angeordnet ist und wobei das Torsionselement zur Drehmomentübertragung mit den Abstützgeometrien einen Formschluss bildet.

Die erfindungsgemäße Verbindung zwischen dem Abrollrohr und dem Dämpferrohr ermöglicht durch das Torsionselement eine Übertragung von Drehmomenten zwischen dem Abrollrohr und dem Dämpferrohr, wobei zugleich auftretende Querkräfte und Kippmomente des Abrollrohres gegenüber dem Dämpferrohr durch das Torsionselement ebenfalls ausgeglichen werden können. Das Torsionselement kann im radial erweiterten Ende des Abrollrohres aufgenommen worden sein und bildet eine formschlüssige Verbindung zu den Abstützgeometrien am Dämpferrohr. Die Drehmomentübertragung wird insbesondere im Bereich des kleineren Radius zwischen dem Torsionselement und den innenliegenden Abstützgeometrien erreicht, so dass durch die formschlüssige Verbindung zwischen dem Torsionselement und dem Dämpferrohr keine sonstige Verbindung geschaffen werden muss, die die auftretende Drehmomentübertragung sicherstellen muss.

Im Betrieb des Federbeins kann eine Relativverdrehung zwischen der Dämpfereinheit und der Luftfedereinheit um die Längsachse der Dämpfereinheit entstehen, und die Drehmomentübertragung zwischen der Luftfedereinheit und der Dämpfereinheit erfolgt insbesondere derart, dass diese durch eine elastische Torsion im Torsionselement begleitet wird. Damit können kleine Winkelverdrehungen des Abrollrohres gegenüber dem Dämpferrohr und damit gegenüber der Dämpfereinheit, entstehen, ohne dass es zu einer dauerhaften Veränderung der Winkellage des Dämpferrohres relativ zum Abrottrohr um die Längsachse der Dämpfereinheit kommt. Insbesondere bietet das Torsionselement eine elastische Nachgiebigkeit zwischen dem Abrollrohr und dem Dämpferrohr um die Längsachse der Dämpfereinheit.

Gemäß einer vorteilhaften Ausführungsform kann das Torsionselement innenseitige Ausnehmungen aufweisen, in denen die Abstützgeometrien einsitzen. Das Torsionselement kann in einem Formgebungsverfahren bzw. in einem Urformverfahren hergestellt sein, mit dem bereits bei der Herstellung die innenseitigen Ausnehmungen im Torsionselement vorgesehen werden können. Die Anzahl der innenseitigen Ausnehmungen des Torsionselementes entspricht dabei vorzugsweise der Anzahl der in segmentierten Bereichen am Dämpferrohr ausgebildeten Abstützgeometrien. Wird das Torsionselement an den Abstützgeometrien angeordnet, insbesondere bei der Montage des Abrollrohres am Dämpferrohr, so können die Abstützgeometrien zunächst in die innenseitigen Ausnehmungen im Torsionselement gefügt werden, und durch eine sich anschließende elastische Verformung des Torsionselementes können sich die innenseitigen Ausnehmungen den Abstützgeometrien zusätzlich anpassen. Beispielsweise können die innenseitigen Ausnehmungen im nicht montierten Zustand des Torsionselementes kleiner ausgeführt sein als die Abstützgeometrien, sodass sich der Formschluss einerseits durch vorgeformte innenseitige Ausnehmungen im Torsionselement und zusätzlich durch eine elastische Nachverformung der Ausnehmungen durch die einsitzenden Abstützgeometrien ausbildet.

Mit weiterem Vorteil kann das Torsionselement mehrteilig ausgeführt und insbesondere aus einem gummielastischen Material gebildet sein und einen formstabilisierenden Körper aufweisen, der vorzugsweise aus einem Hartkunststoffmaterial oder aus einem Metallmaterial hergestellt ist, wobei der Kernkörper vorzugsweise mit dem gummielastischen Material, insbesondere mit einem Nitrilkautschuk oder einem Naturkautschuk, im Spritzguss umspritzt ist. Durch den Kernkörper wird die Formstabilität des Torsionselementes im Betrieb des Federbeins verbessert, insbesondere zur Übertragung von zwischen dem Dämpferrohr und dem Abrollrohr auftretenden Drehmomenten. Zusätzlich kann die Dauerfestigkeit des Torsionselementes über der Gebrauchsdauer des Federbeins im Fahrzeug durch einen formstabilisierenden Kernkörper positiv beeinflusst werden.

Das Federbein kann so ausgeführt sein, dass im Bereich zwischen dem Dämpferrohr und dem Abrollrohr, insbesondere innenseitig im Abrollrohr, ein Druckraum gebildet ist, wobei das Torsionselement eine außenseitig umlaufende Dichtlippe aufweist, die den Druckraum gegen die Innenseite des Abrollrohres abdichtet. Die Dichtlippe kann als geometrische Ausformung des gummielastischen Materials, insbesondere des Nitrilkautschuks oder des Naturkautschuks, ausgebildet und somit mit dem Torsionselement einteilig ausgeführt sein. Beispielsweise kann die Dichtlippe elastisch gegen die Innenseite des Abrollrohres zur Anlage kommen, sodass eine Dichtwirkung zwischen dem Torsionselement und der Innenseite des Abrollrohres entsteht. Das Torsionselement kann derart bündig auf dem Dämpferrohr und insbesondere auf den Abstützgeometrien aufsitzen, dass bereits durch den Sitz des Torsionselementes auf dem Dämpferrohr bzw. auf den Abstützgeometrien eine Dichtwirkung erzielt wird.

Die Abstützgeometrien können beispielsweise durch ein Umformverfahren als nach außen gewölbte Ausformungen in der Wand des Dämpferrohres ausgebildet werden. Beispielsweise können die Ausformungen durch ein elastisches Druckpufferelement im Querpressverfahren oder durch ein Verfahren des Innenhochdruckumformens ausgebildet werden. Auch ist es denkbar, dass die Abstützgeometrien als einzelne Elemente auf der Außenseite des Dämpferrohres aufgebracht werden, beispielsweise mittels einem Lötverfahren, einem Schweißverfahren oder einem sonstigen Verbindungsverfahren.

Auf dem Umfang des Dämpferrohres können vorzugsweise mehrere Abstützgeometrien vorgesehen sein, die sich insbesondere in einer Höhe in Bezug zur Längsachse der Dämpfereinheit befinden, wobei auch bereits eine einzelne Abstützgeometrie ausreichend sein kann. Die Abstützgeometrien sind vorzugsweise in segmentierten Bereichen auf dem Außenumfang des Dämpferrohres angeordnet, und zwischen den Bereichen, in denen die Abstützgeometrien vorhanden sind, weist das Dämpferrohr eine durchgehende Struktur auf, wobei die Steifigkeit und insbesondere die Belastbarkeit des Dämpferrohres in Richtung zur Längsachse erhöht wird. Sind mehrere Abstützgeometrien auf dem Umfang des Dämpferrohres angeordnet, können diese vorzugsweise zueinander gleich verteilt und damit gleich beabstandet sein. Sind beispielsweise drei Abstützgeometrien auf dem Umfang des Dämpferrohres angeordnet, können diese eine Teilung von 120° zueinander aufweisen. Sind mehrere Abstützgeometrien auf dem Umfang des Dämpferrohres verteilt vorgesehen, so reduziert sich insbesondere die mechanische Belastung der einzelnen Abstützgeometrien.

Auch ist es von Vorteil, wenn die Abstützgeometrien eine Stützschulter umfassen, die in Richtung zur Luftfedereinheit weisen, wobei die Abstützgeometrien mit der Stützschulter in den Ausnehmungen des Torsionselementes einsitzen. Die Stützschultern können eine Kraftübertragungsfläche der Abstützgeometrien bilden, die jeweils gegen eine in den innenseitigen Ausnehmungen des Torsionselementes komplementäre Kraftübertragungsfläche anliegen kann.

Vorteilhafterweise ist das Torsionselement mit seinem gummielastischen Material auf der Innenseite des radial erweiterten Endes des Abrollrohres aufvulkanisiert, aufgeklebt oder in das radial erweiterte Ende eingepresst. Dadurch entsteht eine selbsthaltende Anordnung des Torsionselementes am Abrollrohr, wodurch die Handhabung des Abrollrohres und des Torsionselementes bei der Montage des Federbeins verbessert wird. Insbesondere wird ein korrekter Sitz des Torsionselementes im radial erweiterten Ende des Abrollrohres sichergestellt.

Gemäß einem weiteren Ausführungsbeispiel kann das Torsionselement im radial erweiterten Ende des Abrollrohres formschlüssig aufgenommen sein, wobei das radial erweiterte Ende einen nach innen geformten Rand aufweisen kann, insbesondere eine nach innen weisende Bördelkante. Durch den Rand bzw. durch die Bördelkante kann ein Formschluss zwischen dem Torsionselement und dem Abrollrohr in Richtung zur Längsachse gebildet werden, sodass das Torsionselement wenigstens verliersicher, insbesondere sogar mit einer Pressung im radial erweiterten Ende des Abrollrohres aufgenommen ist.

### BEVORZUGTES AUSFÜHRUNGSBEISPIEL DER ERFINGUNG

Weitere, die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Figur 1: ein Ausführungsbeispiel eines Federbeins in einer geschnittenen Seitenansicht mit einer erfindungsgemäßen Anordnung des Abrollrohres einer Luftfedereinheit am Dämpferrohr einer Dämpfereinheit;
- Figur 2: eine ausschnittsweise vergrößerte Ansicht der Anordnung von Abstützgeometrien an einem Dämpferrohr, auf dem ein teilweise dargestelltes Torsionselement gezeigt ist;
- Figur 3: eine perspektivische Ansicht eines geschnitten dargestellten Torsianselementes;
- Figur 4: eine Seitenansicht der Anordnung des Torsionselementes am Dämpferrohr und
- Figur 5: eine Querschnittsansicht des Dämpferrohres mit einem Torsionselement gemäß der Schnittlinie A - A, wie in Figur 4 gezeigt.

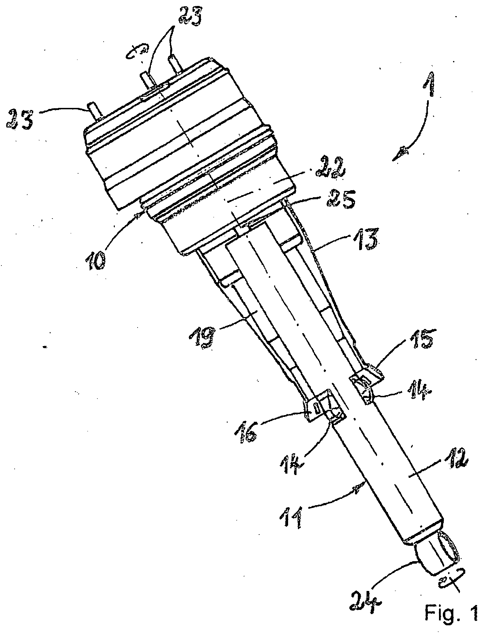

Figur 1 zeigt ein Ausführungsbeispiel eines Federbeins 1 mit den Merkmalen der vorliegenden Erfindung. Das Federbein 1 dient zur Anordnung in einem Fahrzeugfahrwerk und bildet ein Verbindungsglied zwischen einem Fahrzeugdom und einer Achse des Fahrzeugs. Das Federbein 1 weist eine Luftfedereinheit 10 und eine Dämpfereinheit 11 auf. Die Luftfedereinheit 10 dient zur Federung der Achse am Fahrzeugrahmen und die Dämpfereinheit 11 bildet eine Dämpfung der Bewegung der Achse am Fahrzeug. Um das Federbein 1 im Fahrzeug anzuordnen, sind endseitig an der Luftfedereinheit 10 Verbindungsbolzen 23 angeordnet, so dass eine direkte Verbindung eines Teils der Luftfedereinheit 10 einem Federdom des Fahrzeugs hergestellt wird. Die Dämpfereinheit 11 weist ein Dämpferrohr 12 auf und endseitig am Dämpferrohr 12 ist ein Befestigungsauge 24 angeordnet, mit dem die Dämpfereinheit 11 mit der Achse des Fahrzeugs verbunden werden kann.

Das Dämpferrohr 12 der Dämpfereinheit 11 erstreckt sich in ein Abrollrohr 13 der Luftfedereinheit 10 hinein, und die Dämpfereinheit 11 weist ferner eine Kolbenstange 25 auf, die sich in die Luftfedereinheit 10 hinein erstreckt und auf nicht näher gezeigte Weise mit einem Teil der Luftfedereinheit 10 verbunden ist.

Da Abrollrohr 13 ist an Abstützgeometrien 14 abgestützt, die am Dämpferrohr 12 der Dämpfereinheit 11 ausgebildet sind. Hierzu weist das Abrollrohr 13 ein radial erweitertes Ende 15 auf, und innenseitig im radial erweiterten Ende 15 ist ein Torsionselement 16 aufgenommen, über das das Abrollrohr 13 an den Abstützgeometrien 14 abgestützt ist.

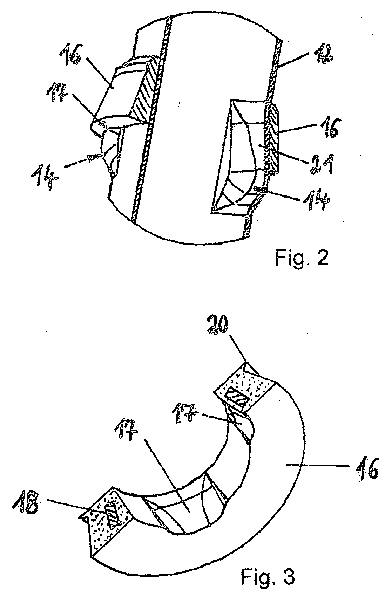

Das Dämpferrohr 12 erstreckt sich entlang einer Längsachse 22 des Federbeins 1, und das Ausführungsbeispiel zeigt drei Abstützgeometrien 14 auf dem Umfang des Dämpferrohres 12, die sich in Bezug auf die Längsachse 22 in einer selben Höhe befinden. Das Torsionselement 16 ist dabei derart auf den Abstützgeometrien 14 angeordnet, dass die Abstützgeometrien 14 innenseitig im Torsionselement 16 einsitzen. Durch das sich radial erweiternde Ende 15 des Abrollrohres 13 entsteht ein Kegelsitz, in dem das Torsionselement kraftübertragend einsitzt. Die Anordnung des Torsionselementes 16 an den Abstützgeometrien 14 des Dämpferrohrs 12 ist in der folgenden Figur 2 näher dargestellt.

Figur 2 zeigt eine Ansicht eines teilweise aufgeschnittenen Dämpferrohres 12, an dem beispielhaft zwei Abstützgeometrien 14 eingebracht sind. Die rechtsseitig dargestellte Abstützgeometrie 14 ist von der Innenseite des Dämpferrohres 12 sichtbar, und es ist erkennbar, dass die Abstützgeometrien 14 als von der Innenseite des Dämpferrohres 12 radiale nach außen gewölbte Ausformungen in der Wand des Dämpferrohres 12 ausgebildet sind. Die Abstützgeometrien 14 weisen eine Stützschulter 21 auf, gegen die das Torsionselement 16 anliegen kann. Hierzu weist das Torsionselement 16 Ausnehmungen 17 auf, in denen die Abstützgeometrien 14 einsitzen können. Dabei entspricht die Anzahl der innenseitig im Torsionselement 16 eingebrachten Ausnehmungen 17 der Anzahl der Abstützgeometrien 14 am Dämpferrohr 12.

Figur 3 zeigt schließlich eine perspektivische Ansicht eines Ausführungsbeispiels eines Torsionselementes 16, wie dieses zur Bildung einer erfindungsgemäßen Verbindung zwischen dem Abrollrohr 13 der Luftfedereinheit 10 und dem Dämpferrohr 12 der Dämpfereinheit 11 ausgeführt sein kann. Das Torsionselement 16 ist im Wesentlichen ringförmig ausgeführt, wobei das Torsionselement 16 hälftig geschnitten dargestellt ist. Innenseitig sind die Ausnehmungen 17 gezeigt, in denen die Abstützgeometrien 14 gemäß Figur 2 einsitzen können. Das Torsionselement 16 befindet sich in der gezeigten Form in einem nicht eingebauten, unbelasteten Zustand, und es ist erkennbar, dass die Ausnehmungen 17 bereits in der geometrischen Grundstruktur des Torsionselementes 16 eingebracht sind.

Da Torsionselement 16 weist ein gummielastisches Material auf, beispielsweise einen Nitrilkautschuk, das im Spritzguss hergestellt ist. Innenseitig besitzt das Torsionselement 16 einen formstabilisierenden Kernkörper 18, der aus einem harten Material, beispielsweise einem Hartkunststoffmaterial oder aus einem Metallmaterial hergestellt ist, und ringförmig mit dem Torsionselement 16 umlaufend ausgebildet ist.

Außenseitig weist das Torsionselement 16 eine im Wesentlichen kegelförmige Kontur auf, die der Kegelform des radial erweiterten Endes 15 des Abrollrohres 13 angepasst ist. An den Ende des Torsionselementes 16, an dem die kegelförmige Außenkontur einen kleineren Durchmesser aufweist, besitzt das Torsionselement 16 eine Dichtlippe 20, die einteilig aus dem gummielastischen Material gebildet ist. Mit der Dichtlippe 20 kann das Torsionselement 16 eine Dichtwirkung gegen die Innenseite des Abrollrohres 13 erfüllen. Die Dichtwirkung zwischen dem Torsionselement 16 und dem Dämpferrohr 12, insbesondere den Abstützgeometrien 14, wird durch den innenseitigen Presssitz des Torsionselementes 16 erreicht. Das radial erweiterte Ende 15 kann entweder lediglich auf der Außenseite des Torsionselementes 16 aufsitzen oder das Torsionselement 16 ist an die Innenseite des radial aufgeweiteten Endes 15 des Abrollrohres 13 aufvulkanisiert oder beispielsweise aufgeklebt.

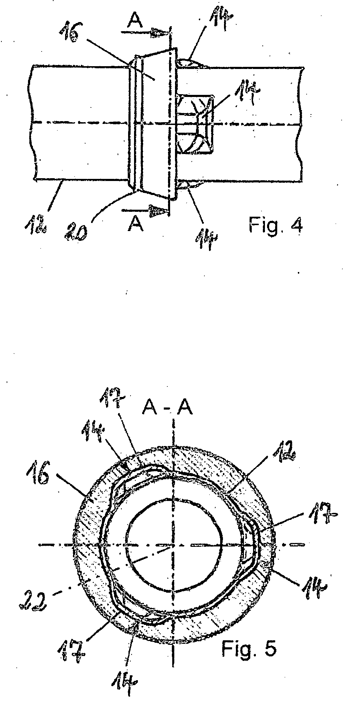

Figur 4 zeigt in einer Seitenansicht die Anordnung des Torsionselementes 16 auf den Abstützgeometrien 14 des Dämpferrohres 12, und auf der Außenseite weist das Torsionselement 16 die Dichtlippe 20 auf. Eine Querschnittansicht des Torsionselementes 16 auf den Abstützgeometrien 14 des Dämpferrohres 12 gemäß der Schnittlinie A - A ist in der folgenden Figur 5 dargestellt.

Figur 5 zeigt eine Querschnittansicht der Anordnung des Torsionselementes 16 am Dämpferrohr 12 gemäß der Schnittlinie A - A. Das Dämpferrohr 12 ist beispielhaft mit drei Abstützgeometrien 14 ausgebildet, die als radial nach außen gewölbte Ausformungen ausgebildet sind. Zur Aufnahme der Abstützgeometrien 14 und damit zur Herstellung einer Formschlussgeometrie weist das Torsionselement 16 Ausnehmungen 17 auf, in denen die Abstützgeometrien 14 einsitzen. Durch den Formschluss zwischen den Ausnehmungen 17 und den Abstützgeometrien 14 wird die Übertragung von Drehmomenten zwischen dem Torsionselement 16 und dem Dämpferrohr 12 um die Längsachse 22 ermöglicht, wodurch sich, wie in Figur 1 gezeigt, eine Verdrehung der Dämpfereinheit 11 gegenüber der Luftfedereinheit 10 im elastischen Bereich des Torsionselementes 16 ergibt. Die elastische und das Drehmoment übertragende Verdrehung der Dämpfereinheit 11 gegenüber der Luftfedereinheit 10 kann einen Winkel von weniger als 10°, bevorzugt von weniger als 5° und besonders bevorzugt von weniger als 1° um die Längsachse 22 betragen.

Gemäß einer noch weiteren Ausführungsform kann das radial erweiterte Ende 15 des Abroltrohres 13 eine Wellenform aufweisen, die komplementär zu den Abstützgeometrien 14 im Dämpferrohr 12 ausgebildet ist. Beispielsweise kann das radial erweiterte Ende 15 drei wellenartige nach außen ausgeformte Ausbuchtungen aufweisen, die in den radialen Positionen im radial erweiterten Ende 15 eingebracht sind, in denen sich auch die Abstützgeometrien 14 befinden. Das Torsionselement 16 kann sich im montierten Zustand in die nach außen ausgeformten Ausbuchtungen im Ende 15 elastische eindrücken, wodurch zwischen dem Torsionselement 16 und dem Abrollrohr 13 ebenfalls ein Formschluss in Verdrehrichtung geschaffen ist.

Die Erfindung beschränkt sich in Ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht. Sämtliche aus den Ansprüchen, der Beschreibung oder den Zeichnungen hervorgehenden Merkmale und/oder Vorteile, einschließlich konstruktiver Einzelheiten oder räumlicher Anordnungen, können sowohl für sich als auch in den verschiedensten Kombinationen erfindungswesentlich sein.

### Bezugszeichenliste

- 1: Federbein

- 10: Luftfedereinheit
- 11: Dämpfereinheit
- 12: Dämpferrohr
- 13: Abrollrohr
- 14: Abstützgeometrie
- 15: radial erweitertes Ende
- 16: Torsionselement
- 17: Ausnehmung
- 18: Kernkörper
- 19: Druckraum
- 20: Dichtlippe
- 21: Stützschulter
- 22: Längsachse
- 23: Verbindungsbolzen
- 24: Befestigungsauge
- 25: Kolbenstange

## Patentansprüche

1. Federbein (1) für ein Fahrzeug mit einer Luftfedereinheit (10) und einer Dämpfereinheit (11), welche Dämpfereinheit (11) ein Dämpferrohr (12) aufweist, das sich in ein Abrollrohr (13) der Luftfedereinheit (10) hinein erstreckt, wobei das Dämpferrohr (12) auf seinem Umfang verteilt angeordnete Abstützgeometrien (14) aufweist, gegen die ein radial erweitertes Ende (15) des Abrollrohres (13) abgestützt ist,
**dadurch gekennzeichnet, dass**
- zur Abstützung des Abrollrohres (13) an den Abstützgeometrien (14) des Dämpferrohres (12) ein Torsionselement (16) vorgesehen ist,
- welches Torsionselement (16) zwischen dem radial erweiterten Ende (15) des Abrollrohres (13) und den Abstützgeometrien (14) des Dämpferrohres (12) angeordnet ist und wobei
- das Torsionselement (16) zur Drehmomentübertragung mit den Abstützgeometrien (14) einen Formschluss bildet.

2. Federbein (1) nach Anspruch 1, **dadurch gekennzeichnet, dass** im Betrieb des Federbeins (1) eine Relatiwerdrehung zwischen der Dämpfereinheit (11) und der Luftfedereinheit (10) um die Längsachse (22) der Dämpfereinheit (11) entsteht, wobei die Drehmomentübertragung zwischen der Luftfedereinheit (10) und der Dämpfereinheit (11) insbesondere durch eine elastische Torsion des Torsionselementes (16) erfolgt.

3. Federbein (1) nach Anspruch 1 oder 2, **dadurch gekennzeichnet, dass** das Torsionselement (16) innenseitige Ausnehmungen (17) aufinreist, in denen die Abstützgeometrien (14) einsitzen.

4. Federbein (1) nach einem der Ansprüche 1 bis 3, **dadurch gekennzeichnet, dass** das Torsionselement (16) mehrteilig ausgeführt ist und insbesondere aus einem gummielastischen Material gebildet ist und einen formstabilisierenden Kernkörper (18) aufweist, der vorzugsweise aus einem Hartkunststoffmaterial oder aus einem Metallmaterial hergestellt ist, wobei der Kernkörper (18) vorzugsweise mit dem gummielastischen Material, insbesondere mit einem Nitrilkautschuk, im Spritzguss umspritzt ist.

5. Federbein (1) nach einem der vorgenannten Ansprüche, **dadurch gekennzeichnet, dass** im Bereich zwischen dem Dämpferrohr (12) und dem Abrollrohr (13) ein Druckraum (19) gebildet ist, wobei das Torsionselement (16) eine außenseitig umlaufende Dichtlippe (20) aufweist, die den Druckraum (19) gegen die Innenseite des Abrollrohres (13) abdichtet.

6. Federbein (1) nach einem der vorgenannten Ansprüche, **dadurch gekennzeichnet, dass** die Abstützgeometrien (14) durch ein Umformverfahren als nach außen gewölbte Ausformungen in der Wand des Dämpferrohres (12) ausgebildet sind.

7. Federbein (1) nach einem der vorgenannten Ansprüche, **dadurch gekennzeichnet, dass** auf dem Umfang des Dämpferrohres (12) drei Abstützgeometrien (14) in einer 120°- Teilung verteilt angeordnet sind.

8. Federbein (1) nach einem der vorgenannten Ansprüche, **dadurch gekennzeichnet, dass** die Abstützgeometrien (14) eine Stützschulter (21) umfassen, die in Richtung zur Luftfedereinheit (10) weisen, wobei die Abstützgeometrien (14) mit der Stützschulter (21) in den Ausnehmungen (17) des Torsionselementes (16) einsitzen.

9. Federbein (1) nach einem der vorgenannten Ansprüche, **dadurch gekennzeichnet, dass** das Torsionselement (16) auf der Innenseite des radial erweiterten Endes (15) des Abrollrohres (13) aufvulkanisiert, aufgeklebt oder in das radial erweiterten Endes (15) eingepresst ist.

10. Federbein (1) nach einem der vorgenannten Ansprüche, **dadurch gekennzeichnet, dass** das Torsionselement (16) im radial erweiterten Ende (15) des Abrollrohres (13) formschlüssig aufgenommen ist, wobei das radial erweiterte Ende (15) einen nach innen geformten Rand aufweist, insbesondere eine nach innen weisende Bördelkante aufweist, durch den bzw. durch die ein Formschluss zwischen dem Torsionselement (16) und dem Abrollrohr (13) in Richtung der Längsachse (22) gebildet ist.

## Claims

1. Suspension strut (1) for a vehicle having an air spring unit (10) and a damper unit (11), which damper unit (11) has a damper tube (12) which extends into a rolling tube (13) of the air spring unit (10), whereby the damper tube (12) having supporting geometries (14) which are arranged distributed on its circumference and against which a radially widened end (15) of the rolling tube (13) is supported,
**characterized in that**
- a torsion element (16) is provided to support the rolling tube (13) on the supporting geometries (14) of the damper tube (12),
- which torsion element (16) is arranged between the radially widened end (15) of the rolling tube (13) and the supporting geometries (14) of the damper tube (12), and whereby
- the torsion element (16) forming a positively locking connection with the supporting geometries (14) for the transmission of torque.

2. Suspension strut (1) according to Claim 1, **characterized in that**, during operation of the suspension strut (1), a relative rotation between the damper unit (11) and the air spring unit (10) is produced about the longitudinal axis (22) of the damper unit (11), whereby the transmission of torque taking place between the air spring unit (10) and the damper unit (11), in particular, by way of an elastic torsion of the torsion element (16).

3. Suspension strut (1) according to Claim 1 or 2, **characterized in that** the torsion element (16) has inner-side recesses (17), in which the supporting geometries (14) are seated.

4. Suspension strut (1) according to one of Claims 1 to 3, **characterized in that** the torsion element (16) is of multiple-piece configuration and is formed, in particular, from a rubbery-elastic material and has a shape-stabilizing core body (18) which is preferably produced from a hard plastic material or from a metal material, whereby the core body (18) preferably being encapsulated by the rubbery-elastic material, in particular by a nitrile rubber, using the injection moulding process.

5. Suspension strut (1) according to one of the preceding claims, **characterized in that** a pressure space (19) is formed in the region between the damper tube (12) and the rolling tube (13), whereby the torsion element (16) having a sealing lip (20) which runs around on the outer side and seals the pressure space (19) against the inner side of the rolling tube (13).

6. Suspension strut (1) according to one of the preceding claims, **characterized in that** the supporting geometries (14) are configured by way of a reshaping process as outwardly curved mouldings in the wall of the damper tube (12).

7. Suspension strut (1) according to one of the preceding claims, **characterized in that** three supporting geometries (14) are arranged distributed at a 120° separation on the circumference of the damper tube (12).

8. Suspension strut (1) according to one of the preceding claims, **characterized in that** the supporting geometries (14) comprise a supporting shoulder (21), which supporting shoulders (21) point in the direction of the air spring unit (10), whereby the supporting geometries (14) being seated by way of the supporting shoulder (21) in the recesses (17) of the torsion element (16).

9. Suspension strut (1) according to one of the preceding claims, **characterized in that** the torsion element (16) is vulcanized or adhesively bonded on the inner side of the radially widened end (15) of the rolling tube (13), or is pressed into the radially widened end (15).

10. Suspension strut (1) according to one of the preceding claims, **characterized in that** the torsion element (16) is received in the radially widened end (15) of the rolling tube (13) in a positively locking manner, whereby the radially widened end (15) having an inwardly shaped edge, in particular an inwardly pointing flange edge, by way of which a positively locking connection is formed between the torsion element (16) and the rolling tube (13) in the direction of the longitudinal axis (22).

## Revendications

1. Jambe de force (1) pour un véhicule avec une unité de ressort pneumatique (10) et une unité d'amortisseur (11), ladite unité d'amortisseur (11) comportant un tube d'amortisseur (12) s'étendant vers l'intérieur dans un tube de déroulement (13) de l'unité de ressort pneumatique (10), le tube d'amortisseur (12) comportant sur sa périphérie des formes géométriques de maintien (14) disposées de façon répartie contre lesquelles une extrémité (15) élargie dans le plan radial du tube de déroulement (13) est maintenue ;
**caractérisée en ce que** :
- un élément de torsion (16) est prévu pour maintenir le tube de déroulement (13) contre les formes géométriques de maintien (14) du tube d'amortisseur (12) ;
- ledit élément de torsion (16) est disposé entre l'extrémité (15) élargie dans le plan radial du tube de déroulement (13) et les formes géométriques de maintien (14) du tube d'amortisseur (12) ; et
- l'élément de torsion (16) forme une complémentarité de formes avec les formes géométriques de maintien (14) pour la transmission d'un couple de rotation.

2. Jambe de force (1) selon la revendication 1, **caractérisée en ce qu'**en situation de fonctionnement de la jambe de force (1), une torsion relative se produit entre l'unité d'amortisseur (11) et l'unité de ressort pneumatique (10) autour de l'axe longitudinal (22) de l'unité d'amortisseur (11), la transmission de couple de rotation se produisant entre l'unité de ressort pneumatique (10) et l'unité d'amortisseur (11), notamment par une torsion élastique de l'élément de torsion (16).

3. Jambe de force (1) selon la revendication 1 ou 2, **caractérisée en ce que** l'élément de torsion (16) comporte des évidements (17) du côté intérieur dans lesquels reposent les formes géométriques de maintien (14).

4. Jambe de force (1) selon l'une quelconque des revendications 1 à 3, **caractérisée en ce que** l'élément de torsion (16) est réalisé en plusieurs parties et est notamment formé en matière matériau élastique de type caoutchouc et comporte un corps de noyau (18) à stabilisation de forme de préférence fabriqué à partir d'une matière plastique dure ou d'un matériau métallique, le corps de noyau (18) étant de préférence injecté par moulage par injection avec le matériau élastique de type caoutchouc, notamment avec un caoutchouc de nitrile.

5. Jambe de force (1) selon l'une quelconque des revendications précédentes, **caractérisée en ce qu'**une chambre de pression (19) est formée dans la zone située entre le tube d'amortisseur (12) et le tube de déroulement (13), l'élément de torsion (16) comportant une lèvre étanche (20) circonférentielle du côté extérieur étanchéifiant la chambre de pression (19) contre le côté intérieur du tube de déroulement (13).

6. Jambe de force (1) selon l'une quelconque des revendications précédentes, **caractérisée en ce que** les formes géométriques de maintien (14) sont réalisées par le biais d'un procédé de transformation, sous la forme de bombements cintrés vers l'extérieur réalisés dans la paroi du tube d'amortisseur (12).

7. Jambe de force (1) selon l'une quelconque des revendications précédentes, **caractérisée en ce que** trois formes géométriques de maintien (14) sont disposées de façon répartie sur la périphérie du tube d'amortisseur (12), à une distance de 120°.

8. Jambe de force (1) selon l'une quelconque des revendications précédentes, **caractérisée en ce que** les formes géométriques de maintien (14) comprennent un épaulement de maintien (21) orienté en direction de l'unité de ressort pneumatique (10), les formes géométriques de maintien (14) reposant avec l'épaulement de maintien (21) dans les évidements (17) de l'élément de torsion (16).

9. Jambe de force (1) selon l'une quelconque des revendications précédentes, **caractérisée en ce que** l'élément de torsion (16) est vulcanisé sur le côté intérieur de l'extrémité (15) élargie dans le plan radial du tube de déroulement (13), de façon à être collé sur l'extrémité (15) élargie dans le plan radial ou comprimé dans celle-ci.

10. Jambe de force (1) selon l'une quelconque des revendications précédentes, **caractérisée en ce que** l'élément de torsion (16) est reçu par complémentarité de formes dans l'extrémité (15) élargie dans le plan radial du tube de déroulement (13), l'extrémité (15) élargie dans le plan radial comportant une bordure formée vers l'intérieur, notamment une arête de sertissage orientée vers l'intérieur à travers laquelle une complémentarité de formes est réalisée entre l'élément de torsion (16) et le tube de déroulement (13) en direction de l'axe longitudinal (22).
